# EUROPEAN PATENT APPLICATION

(11) **EP 4 694 617 A1**
(43) Date of publication of application: **11.02.2026**
(21) Application number: 24893296.4
(22) Date of filing: 12.11.2024
(51) Int. Cl.: H10D 30/66, H10D 30/01

(54) **VERTICAL SEMICONDUCTOR DEVICE AND MANUFACTURING METHOD THEREFOR**

(30) Priority: 22.11.2023 CN 202311579690
(71) Applicant: Diodes Incorporated, Plano, Texas 75024 (US)
(72) Inventor: KUO, Ta-Chuan, New Taipei City Taiwan 231023 (CN); CHUANG, Chiao-Shun, New Taipei City Taiwan 231023 (CN)
(74) Representative: Marks & Clerk LLP
(86) International application number: PCT/CN2024/131457
(87) International publication number: WO 2025/108138

(57) **Abstract**

The present invention provides a vertical semiconductor device and a method for manufacturing the vertical semiconductor structure. The vertical semiconductor structure comprises a semiconductor material layer, a first shield structure located in the semiconductor material layer, the first shield structure comprising a first shield dielectric layer and a first shield electrode surrounded by the first shield dielectric layer, a first doped region located in the semiconductor material layer, the first doped region having a first conductivity type, and a first gate structure adjacent to the first doped region. A depth of the first gate structure is less than a depth of the first shield structure and greater than a depth of the first doped region. A bottom of the first gate structure defines a boundary that divides the first shield dielectric layer into an upper portion and a lower portion, and the first gate structure is adjacent to the upper portion of the first shield dielectric layer. The upper portion has a first thickness at the first surface of the semiconductor material layer. The first thickness is less than a second thickness of the lower portion. A sum of the first thickness of the upper portion and a third thickness of the first gate structure at the first surface is greater than the second thickness of the lower portion.

## Description

### TECHNICAL FIELD

The present disclosure relates to a vertical semiconductor device and a manufacturing method therefor, and more specifically, to a vertical semiconductor device having a gate electrode structure partially located in a mesa region and partially located in a shield trench structure, and a method for manufacturing such a vertical semiconductor device.

### BACKGROUND

A trench-type metal-oxide-semiconductor field-effect transistor (trench-MOSFET) has a gate electrode buried in a trench within the substrate, which can form a vertical-type channel. The main advantage of this structure is the absence of a junction field-effect transistor (JFET) effect. During the development of semiconductor technology, as the minimum manufacturable component size decreases, the number of interconnected devices per unit area increases accordingly. The allowable contact area between conductive elements in the current conduction path becomes limited, leading to increased device resistance or reduced product reliability. For example, when the gate area of a trench-type MOSFET is limited, it can result in a large gate resistance, thereby leading to lower efficiency and slower switching speed. If the gate area is increased, it will reduce the spacing between the shield electrode and the gate, which in turn will lower the sustainable voltage between the gate and the source, resulting in decreased reliability.

### SUMMARY

Embodiments of the present disclosure relate to a vertical semiconductor device, comprising: a semiconductor material layer comprising a first surface and a second surface opposite each other; a first shield structure located in the semiconductor material layer and extending from the first surface toward the second surface, the first shield structure comprising a first shield dielectric layer and a first shield electrode surrounded by the first shield dielectric layer; a first doped region located in the semiconductor material layer and adjacent to the first surface, the first doped region having a first conductivity type; and a first gate structure located in the semiconductor material layer and extending from the first surface toward the second surface, the first gate structure being adjacent to the first doped region, a depth of the first gate structure being less than a depth of the first shield structure and greater than a depth of the first doped region. A bottom of the first gate structure defines a boundary that divides the first shield dielectric layer into an upper portion and a lower portion, and the first gate structure is adjacent to the upper portion of the first shield dielectric layer. The upper portion of the first shield dielectric layer has a first thickness at the first surface of the semiconductor material layer, the first thickness being less than a second thickness of the lower portion of the first shield dielectric layer. A sum of the first thickness of the upper portion of the first shield dielectric layer and a third thickness of the first gate structure at the first surface is greater than the second thickness of the lower portion of the first shield dielectric layer.

In some embodiments, the first gate electrode structure includes a first gate electrode and a first gate dielectric layer, wherein the first gate electrode contacts the upper portion of the first shield dielectric layer, and the first gate dielectric layer is located between the first gate electrode and the semiconductor material layer.

In some embodiments, a width of a top portion of the first gate electrode is greater than a width of a bottom portion of the first gate electrode.

In some embodiments, a sum of a width of the first gate electrode at the first surface and the first thickness of the upper portion of the first shield dielectric layer is greater than or equal to the second thickness of the lower portion of the first shield dielectric layer.

In some embodiments, the first gate electrode structure comprises a first sidewall away from the first shield structure and a second sidewall adjacent to the first shield structure, the first sidewall being planar and the second sidewall being a sidewall having a stepped configuration.

In some embodiments, in a top view, a portion of the first gate structure overlaps the first shield structure, and a portion of the first gate structure located outside a coverage range of the first shield structure.

In some embodiments, the upper portion of the first shield dielectric layer comprises a first sidewall portion extending along a first direction, a second sidewall portion substantially parallel to the first sidewall portion, and a third sidewall portion connecting the first sidewall portion and the second sidewall portion and extending along a second direction, an included angle between the first direction and the second direction being between 30 ° and 90 °.

In some embodiments, the vertical semiconductor device further includes: a second shield structure located in the semiconductor material layer and extending from the first surface toward the second surface, the second shield structure being adjacent to the first shield structure, the first doped region being located at least between the first shield structure and the second shield structure, the second shield structure comprising a second shield dielectric layer and a second shield electrode surrounded by the second shield dielectric layer; and a second gate structure located in the semiconductor material layer and extending from the first surface toward the second surface, a configuration of the second gate structure being substantially symmetric to a configuration of the first gate structure.

In some embodiments, the vertical semiconductor device further includes: a second doped region located in the semiconductor material layer and adjacent to the first surface, the second doped region being within the first doped region and having a second conductivity type different from the first conductivity type, and a depth of the first doped region being greater than a depth of the second doped region.

In some embodiments, the vertical semiconductor device further includes: a source-electrode layer located over the first surface of the semiconductor material layer; a first conductive plug electrically connected to the first shield structure; and a third doped region located within the first shield electrode and adjacent to the first conductive plug, a concentration of dopants of the first conductivity type in the third doped region being greater than a concentration of dopants of the first conductivity type in the first doped region.

Embodiments of the present disclosure relate to a manufacturing method for a vertical semiconductor device. The method includes: forming a first shield structure in a lightly doped region of a semiconductor material layer, the lightly doped region having a first conductivity type, the first shield structure comprising a first shield electrode and a first shield dielectric layer located between the first shield electrode and the semiconductor material layer; forming a first patterned layer on the semiconductor material layer, the first patterned layer having a first opening, wherein a first sidewall of the first opening is located above the first shield dielectric layer located between the first shield electrode and the semiconductor material layer, and a first sidewall of the first shield dielectric layer is located within a coverage range of the opening; performing a first etching process on the first shield dielectric layer to form a first recess in the first shield dielectric layer, the first recess exposing a portion of the semiconductor material layer; performing a second etching process on the semiconductor material layer to form a second recess in the semiconductor material layer, a depth of the second recess being greater than a depth of the first recess, the second recess exposing the first sidewall of the first shield dielectric layer located below the first recess, and the first recess communicating with the second recess to define a third recess; and forming a first gate structure in the third recess.

In some embodiments, forming the first shield structure in the semiconductor material layer includes forming a first trench in the semiconductor layer, forming the first shield dielectric layer along sidewalls of the first trench, and forming the first shield electrode in the first trench, a top surface of the first shield electrode, a top surface of the first shield dielectric layer, and a top surface of the semiconductor material layer being at approximately the same level.

In some embodiments, the manufacturing method further includes after forming the first gate structure, performing a first ion implantation process on the semiconductor material layer to form a body doped region, the body doped region having a second conductivity type different from that of the lightly doped region.

In some embodiments, a depth of the body doped region is less than a depth of the first gate structure.

In some embodiments, the manufacturing method further includes performing a second ion implantation process on the semiconductor material layer to form a source doped region, wherein the source doped region has the same first conductivity type as the lightly doped region, and a concentration of dopants of the first conductivity type in the source doped region is greater than a concentration of dopants of the first conductivity type in the lightly doped region.

In some embodiments, the second recess exposes a portion of the semiconductor material layer adjacent to the first shield structure, and the manufacturing method further includes: after the second etching process, forming a first sacrificial layer on an exposed portion of the semiconductor material layer in the second recess; and removing the first sacrificial layer before forming the first gate structure.

In some embodiments, forming the first gate electrode structure includes: forming a first gate dielectric layer on the semiconductor material layer in the third recess; and forming a first gate electrode in the third recess, a width of an upper portion of the first gate electrode being greater than a width of a lower portion of the first gate electrode.

In some embodiments, the width of the upper portion of the first gate electrode is between 0.6 µm and 0.8 µm.

In some embodiments, a portion of the first shield dielectric layer adjacent to the upper portion of the first gate electrode has a thickness is between 0.1 µm and 0.2 µm.

In some embodiments, a thickness of the first shield dielectric layer beneath the first gate electrode is between 0.6 µm and 0.8 µm.

In some embodiments, the manufacturing method further includes forming a first conductive plug electrically connected to the first shield structure; and forming a second conductive plug electrically connected to the first gate structure.

In some embodiments, a depth of the first conductive plug or the second conductive plug in the semiconductor material layer is greater than a depth of the source doped region in the semiconductor material layer.

In some embodiments, at least one of the first etching process and the second etching process is a dry etching process.

### BRIEF DESCRIPTION OF THE DRAWINGS

Aspects of several embodiments of the present disclosure may be best understood when the following detailed description is read in conjunction with the accompanying drawings. It should be noted that various structures may not be drawn to scale. In fact, the dimensions of various structures may be arbitrarily enlarged or reduced for clarity of discussion.
FIGS. 1 to 27 are cross-sectional views illustrating one or more stages in a manufacturing method of a vertical semiconductor device according to various embodiments of the present disclosure;
FIG. 28 is a top view of a vertical semiconductor device according to various embodiments of the present disclosure; and
FIG. 29 is a cross-sectional view of a vertical semiconductor device according to various embodiments of the present disclosure.

The same or similar components are marked with the same reference numerals in the drawings and detailed description. Several embodiments of the present disclosure will be readily understood from the following detailed description in conjunction with the accompanying drawings.

### DETAILED DESCRIPTION OF ILLUSTRATIVE EMBODIMENTS

The following disclosure provides various different embodiments or examples for implementing different features of the presented subject matter. Specific embodiments of components and configurations are described below. Certainly, these are examples only and are not intended to be limiting. In this disclosure, references to forming a first feature over or on a second feature may include embodiments where the first and second features are formed in direct contact, and may also include embodiments where an additional feature is formed between the first feature and the second feature such that the first feature and the second feature may not be in direct contact. In addition, the present disclosure may repeat reference signs and/or letters in various embodiments. Such repetition is for simplicity and clarity and does not in itself indicate relationships between the various embodiments and/or configurations discussed.

Embodiments of the present disclosure are discussed in detail below. It should be appreciated, however, that the present disclosure provides applicable concepts that can be embodied in a wide variety of specific contexts. The specific embodiments discussed herein are illustrative only, and do not limit the scope of the present disclosure.

The present disclosure provides a structure of a semiconductor rectifier device and a method for manufacturing the same. Compared with conventional methods for manufacturing semiconductor rectifier devices, the semiconductor rectifier device of the present disclosure includes a Schottky barrier structure. Furthermore, the Schottky barrier rectifier of the present disclosure has a lower electric field intensity at the metal-semiconductor interface, thereby achieving the effect of maintaining a low forward voltage (VF) while reducing reverse current (IR), and improving reverse leakage performance. Therefore, the structure of the present disclosure can reduce IR without increasing VF, and provides a rectifier device with improved reverse leakage characteristics.

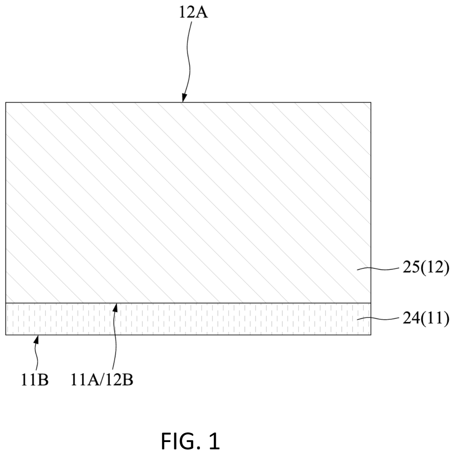

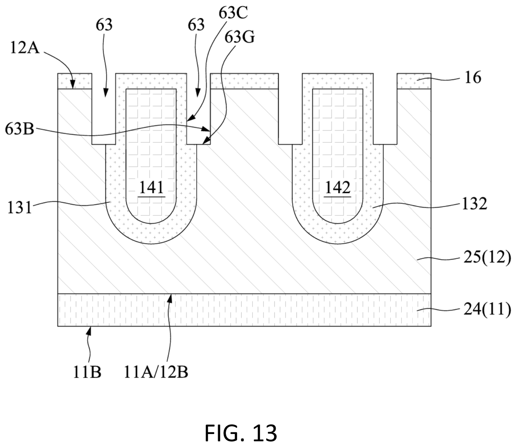

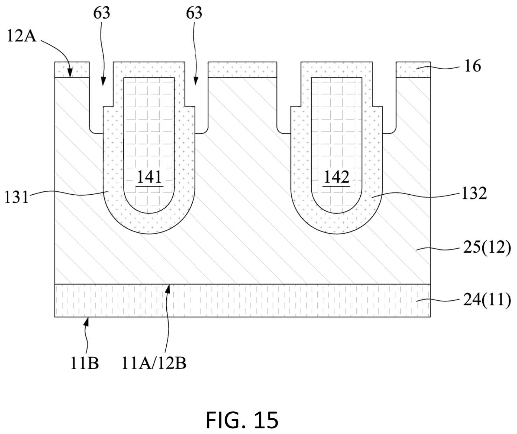

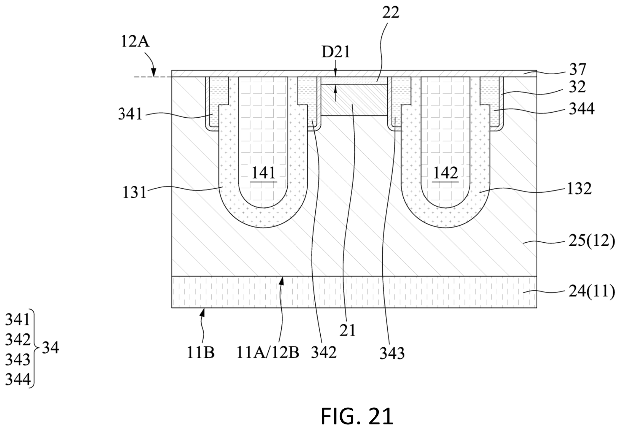

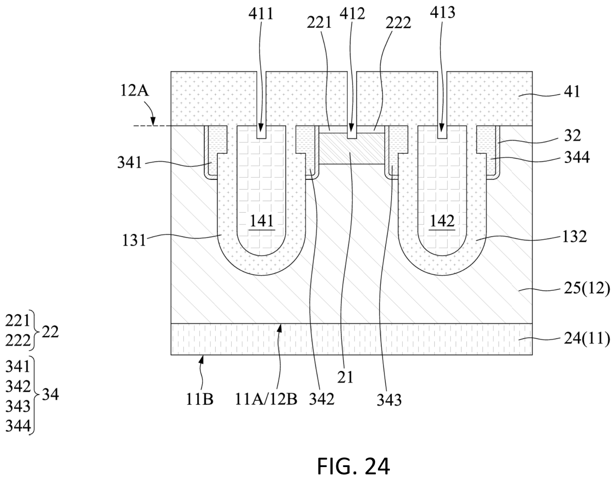

FIGS. 1 to 28 illustrate one or more stages in a manufacturing method of a vertical semiconductor device 1 according to various embodiments of the present disclosure. At least some of the drawings have been simplified to better facilitate understanding of aspects of the present disclosure.

Referring to FIG. 1, the manufacturing method of the vertical semiconductor device 1 includes forming a semiconductor material layer 12 on a surface 11A of a substrate 11, and forming a doped region 25 in the semiconductor material layer 12. The semiconductor material layer 12 is, for example, formed by epitaxial growth on the surface 11A of the substrate 11. The substrate 11 has opposing surfaces 11A and 11B. In some embodiments, the surfaces 11A and 11B may be horizontal planes. For convenience of description, the direction perpendicular to surfaces 11A and 11B is defined as the vertical direction, and the direction perpendicular to the vertical direction is defined as the horizontal direction. In some embodiments, the surface 11A is the top surface of the substrate 11, and the surface 11B is the bottom surface of the substrate 11. In some embodiments, the surface 11A is the top surface of a silicon wafer. The substrate 11 shown in FIG. 1 may represent only the portion of the silicon wafer near the top surface. The material of the substrate 11 may be polysilicon or monocrystalline silicon. The substrate 11 may include a doped region 24. For example, the substrate 11 may include a p-type doped region configured for forming an n-type transistor and an n-type doped region configured for forming a p-type transistor. The n-type doped region is doped with n-type dopants such as phosphorus, arsenic, other n-type dopants, or combinations thereof. The p-type doped region is doped with p-type dopants such as boron, indium, other p-type dopants, or combinations thereof. The n-type or p-type doped regions may be formed by ion implantation, diffusion, and/or other suitable doping processes. The doped region 24 of the substrate 11 extends from the surface 11A toward the surface 11B. In some embodiments, the doped region 24 of the substrate 11 covers the entire surface 11A. In some embodiments, the doped region 24 of the substrate 11 has a first conductivity type. For ease of explanation, the following description takes N-type as the first conductivity type and P-type as the second conductivity type as examples, but the present disclosure is not limited thereto. The substrate 11 may be configured as N-type (first conductivity type) or P-type (second conductivity type) depending on the conductivity type of the vertical semiconductor device 1. It should be noted that the substrate 11 shown in FIG. 1 may represent only a portion of the silicon wafer near the top surface, or in other words, FIG. 1 may only show a portion of the doped region 24 of the substrate 11. In some embodiments, the doped region 24 of the substrate 11 serves as the cathode-doped region of the vertical semiconductor device 1.

The semiconductor material layer 12 has the same conductivity type as the substrate 11, that is, the first-type doping. The material of the substrate 11 may be polysilicon, monocrystalline silicon, silicon carbide, silicon germanium, or other suitable semiconductor materials. In some embodiments, ions having N-type conductivity are introduced during the epitaxial growth to form an N-type semiconductor material layer 12, without the need for an additional ion implantation process. Therefore, the N-type conductive ions may be distributed throughout the semiconductor material layer 12 to form a doped region 25 that is located throughout the entire semiconductor material layer 12. The semiconductor material layer 12 may have a surface 12A and a surface 12B opposite to surface 12A. In some embodiments, the surface 12A and the surface 12B may be horizontal planes. In some embodiments, the surface 12A is a top surface of the semiconductor material layer 12, and the surface 12B is a bottom surface of the semiconductor material layer 12. In some embodiments, the surface 12B of the semiconductor material layer 12 is in direct contact with the surface 11A of the substrate 11.

The thickness and doping concentration of the semiconductor material layer 12 may be adjusted according to the voltage requirements of the device. In some embodiments, the semiconductor material layer 12 may have a uniform doping concentration. In some embodiments, ions having N-type conductivity are introduced uniformly during the epitaxial growth process to form the semiconductor material layer 12 with a uniform doping concentration, wherein the concentration of ions introduced during the epitaxial growth does not change over time. In some embodiments, the semiconductor material layer 12 may have a doping concentration gradient that increases or decreases from surface 12A to surface 12B. In some embodiments, the increasing or decreasing doping concentration gradient may be adjusted based on the required breakdown voltage and resistance of the product. In some embodiments, ions having N-type conductivity are introduced during the epitaxial-growth process, and the concentration of the introduced ions is decreased or increased as the epitaxial growth proceeds, thereby forming the semiconductor material layer 12 with a decreasing or increasing dopant concentration. Regardless of whether the semiconductor material layer 12 has a uniform or a non-uniform dopant concentration, the dopant concentration of the substrate 11 is still greater than that of the semiconductor material layer 12. For ease of description, the doped region 25 is hereinafter collectively referred to as the lightly-doped region 25.

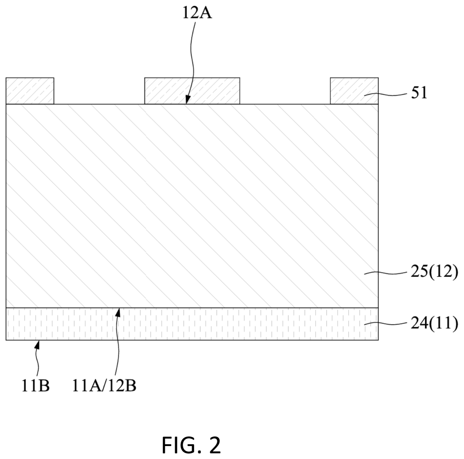

Referring to FIG. 2, the manufacturing method of the vertical semiconductor device 1 includes forming a patterned layer 51 on the surface 12A of the semiconductor material layer 12 to expose a portion of the semiconductor material layer 12. The patterned layer 51 is used to define the position of the trench for the subsequently formed shield electrode structure. In some embodiments, the patterned layer 51 includes openings 511 and 512 that expose portions of the semiconductor material layer 12. The patterned layer 51 may be a layer of photoresist, hard mask layer, dielectric layer (such as an oxide layer or a nitride layer), or other material layer suitable for use as a mask in subsequent etching processes. In some embodiments, the patterned layer 51 includes an oxide (e.g., silicon oxide). In some embodiments, an oxide layer is deposited to entirely cover the surface 12A of the semiconductor material layer 12, a patterned photoresist layer is then formed on the oxide layer and used to remove portions of the oxide layer, and then the patterned photoresist layer is removed to form the patterned layer 51 that exposes portions of the silicon carbide layer 12.

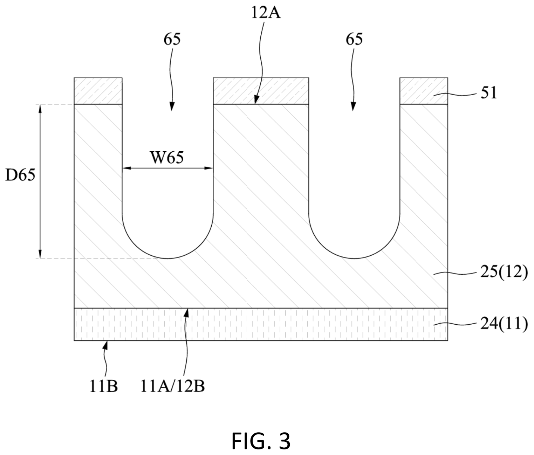

Referring to FIG. 3, the manufacturing method of the vertical semiconductor device 1 includes etching the semiconductor material layer 12 with the patterned layer 51 as a mask to form a plurality of trenches 65 (for example, trenches 651 and 652). The plurality of trenches 65 are adjacent to each other and extend from the surface 12A of the semiconductor material layer 12 toward the surface 12B. Because they are formed through the same etching step, the trenches 651 and 652 have approximately the same depth D65. In some embodiments, the depth D65 of the trench 651 or the trench 652 is between 5-30 µm. In some embodiments, the depth D65 of the trench 651 or the trench 652 is between 8-10 µm. The widths of the trenches 651 and 652 may be determined by the openings 511 and 512. In some embodiments, the trenches 651 and 652 have approximately the same width W65. In some embodiments, the width W65 of the trench 651 or the trench 652 is between 0.5-5 µm. In some embodiments, the width W65 of the trench 651 or the trench 652 is between 2-3 µm. The widths and depths of the trenches 651 and 652 may be set and adjusted according to the voltage required by the device. Within the ranges of the embodiments disclosed above, increasing the depth D65 of trenches 651 and 652 lowers the resistivity of the semiconductor material layer 12.

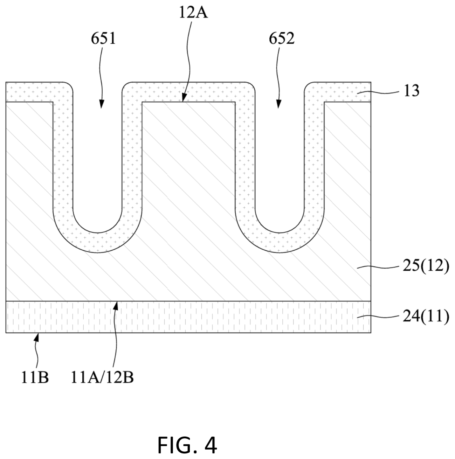

Referring to FIG. 4, the manufacturing method of the vertical semiconductor device 1 includes forming a dielectric layer 13 to fill the trenches 651 and 652. In some embodiments, the dielectric layer 13 may be formed by atomic layer deposition (ALD), chemical vapor deposition (CVD), or other deposition processes. In some embodiments, the dielectric layer 13 may be formed by thermal oxidation. In some embodiments, the dielectric layer 13 is deposited in trenches 651 and 652. In some embodiments, the dielectric layer 13 may be deposited conformally on inner surfaces of the trenches 651 and 652 (including opposing sidewalls and a bottom extending between the sidewalls) and on the surface 12A of the semiconductor material layer 12. In some embodiments, the dielectric layer 13 may be filled into the trenches 651 and 652 through a deposition process, and then photolithography and etching processes are carried out to selectively remove portions of the dielectric layer 13, thereby forming at least one recess in the dielectric layer 13. The thickness of the dielectric layer 13 may be set and adjusted according to the voltage required by the device. In some embodiments, the thickness of the dielectric layer 13 is between 0.1-2 µm. In some embodiments, the thickness of the dielectric layer 13 is between 0.2-1.2 µm. In some embodiments, the thickness of the dielectric layer 13 is between 0.6-0.8 µm.

The voltage rating of the vertical semiconductor device 1 is largely determined by both the dopant concentration of the semiconductor material layer 12 and the thickness of the dielectric layer 13, therefore, the steps illustrated in FIGS. 1 and 4 dictate the voltage of the vertical semiconductor device 1.

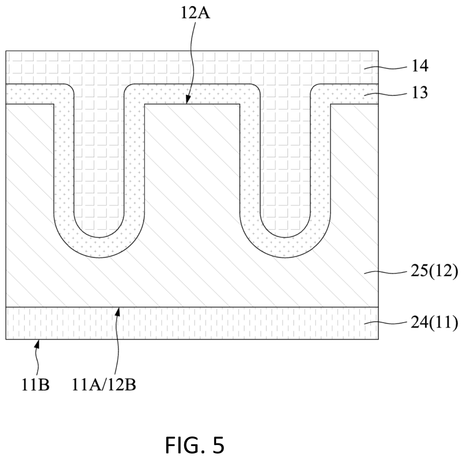

Referring to FIG. 5, the manufacturing method of the vertical semiconductor device 1 includes forming an electrode material layer 14 to fill the trenches 651 and 652. In some embodiments, the electrode material layer 14 may be formed by physical vapor deposition (PVD), CVD, or other deposition processes. In some embodiments, the electrode material layer 14 fills the trenches 651 and 652 and covers the surface 12A of the semiconductor material layer 12. In some embodiments, the electrode material layer 14 includes a semiconductor material, for example polysilicon.

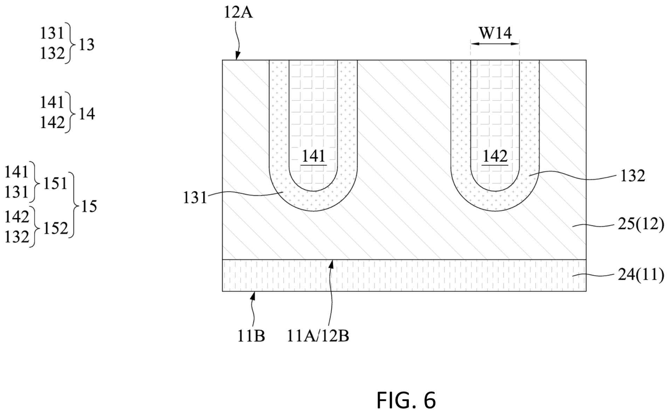

Referring to FIG. 6, the manufacturing method of the vertical semiconductor device 1 includes removing portions of the electrode material layer 14 and the dielectric layer 13 that are located outside the trenches 651 and 652. In some embodiments, the electrode material layer 14 outside the trenches 651 and 652 is removed so as to respectively form a first electrode layer 141 and a second electrode layer 142 in the trenches 651 and 652. In some embodiments, a grinding process is performed on the electrode material layer 14, for example, a chemical mechanical polishing (CMP) process, to remove the electrode material layer 14 outside the trenches 651 and 652. In some other embodiments, the method of removing portions of the electrode material layer 14 located outside the trenches 651 and 652 may further include an etching process, for example, a wet etching process or a dry etching process. In some embodiments, after removing the electrode material layer 14 above the surface 12A of the semiconductor material layer 12, a similar process is performed on the dielectric layer 13 so as to respectively form a first dielectric layer 131 and a second dielectric layer 132 in the trenches 651 and 652. In some embodiments, the top surfaces of the dielectric layer 13 and the top surfaces of the electrode material layer 14 after etching lie at approximately the same horizontal level. In some embodiments, the top surfaces of the dielectric layer 13 and the top surfaces of the electrode material layer 14 after etching are coplanar with the surface 12A. The vertical semiconductor device 1 includes a double-trench-gate semiconductor power device, in which the dielectric layer 13 (including the first dielectric layer 131 and the second dielectric layer 132) serves as a shield dielectric layer of a shield electrode structure 15, and the electrode material layer 14 (including the first electrode layer 141 and the second electrode layer 142) serves as a shield electrode layer of the shield electrode structure 15. The first dielectric layer 131 surrounds the first electrode layer 141, and the second dielectric layer 132 surrounds the second electrode layer 142, respectively defining different shield structures 15 of the vertical semiconductor device 1. For convenience of description, the first electrode layer 141 together with the first dielectric layer 131 is collectively referred to as a first shield structure 151. Similarly, the second electrode layer 142 together with the second dielectric layer 132 is collectively referred to as a second shield structure 152. In some embodiments, the top surfaces of the first electrode layer 141 and the second electrode layer 142 are coplanar with the surface 12A. In some embodiments, the top surfaces of the first dielectric layer 131 and the second dielectric layer 132 are coplanar with the surface 12A. In some embodiments, the first electrode layer 141 and the second electrode layer 142 have approximately the same width W14. In some embodiments, a range of the width W14 is between 0.3-3 µm. In some embodiments, a range of the width W14 is between 0.6-1 µm. In some embodiments, the ratio of the width W14 to the width W651 of the trench 65 is greater than or equal to 3:1.

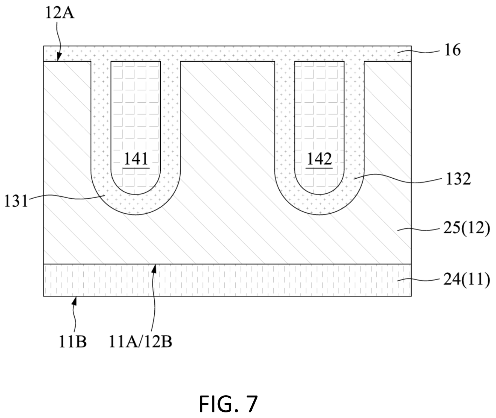

Referring to FIG. 7, the manufacturing method of the vertical semiconductor device 1 includes forming a hard mask layer 16 on the surface 12A of the semiconductor material layer 12. The hard mask layer 16 covers the first shield structure 151, the second shield structure 152, and the surface 12A of the semiconductor material layer 12. The hard mask layer 16 may include a dielectric material (for example, an oxide layer or a nitride layer) or other material layers suitable for serving as a mask in subsequent etching processes. In the subsequent step of defining the gate structure, portions of the dielectric layers 131 and 132 will be removed. In some embodiments, in order to simplify steps and reduce manufacturing cost, the hard mask layer 16 may be selected to use the same dielectric material as the dielectric layer 13. In some embodiments, the material of the hard mask layer 16 is an oxide (for example, silicon oxide).

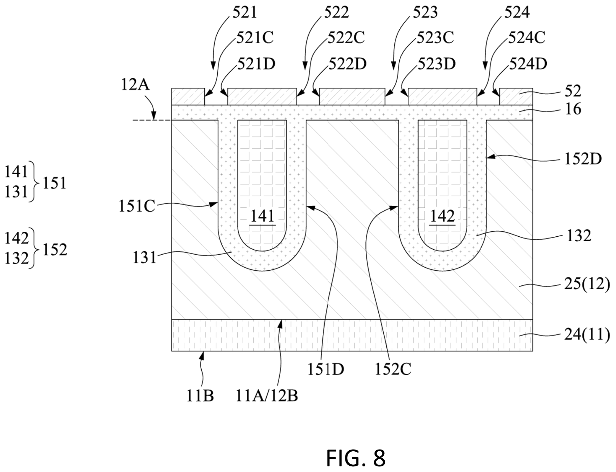

Referring to FIG. 8, the manufacturing method of the vertical semiconductor device 1 includes forming a patterned layer 52 on the top surface of the hard mask layer 16. The patterned layer 52 has multiple openings located above opposing sidewalls of the shield structures (for example, 521, 522, 523, and 524 in FIG. 8). For example, the first shield structure 151 has two opposing sidewalls 151C and 151D. The opening 521 of the patterned layer 52 is located above the sidewall 151C, and the opening 522 of the patterned layer 52 is located above the sidewall 151D. In some embodiments, the sidewall 151C is located within a coverage range of a vertical projection of the opening 521, and the sidewall 151D is located within a coverage range of a vertical projection of the opening 522. In some embodiments, the opening 521 has two opposing sidewalls 521C and 521D, and an extension line of the sidewall 151C in the vertical direction is located between an extension line of the sidewall 521C and an extension line of the sidewall 521D. In some embodiments, the opening 522 has two opposing sidewalls 522C and 522D, and an extension line of the sidewall 151D in the vertical direction is located between an extension line of the sidewall 522C and an extension line of the sidewall 522D. Similarly, for example, the second shield structure 152 has two opposing sidewalls 152C and 152D. The opening 523 is located above the sidewall 152C, and the opening 524 is located above the sidewall 152D. In some embodiments, the sidewall 152C is located within a coverage range of a vertical projection of the opening 523, and the sidewall 152D is located within a coverage range of a vertical projection of the opening 524. In some embodiments, the opening 523 has two opposing sidewalls 523C and 523D, and an extension line of the sidewall 152C in the vertical direction is located between an extension line of the sidewall 523C and an extension line of the sidewall 523D. In some embodiments, the opening 524 has two opposing sidewalls 524C and 524D, and an extension line of the sidewall 152D in the vertical direction is located between an extension line of the sidewall 524C and an extension line of the sidewall 524D.

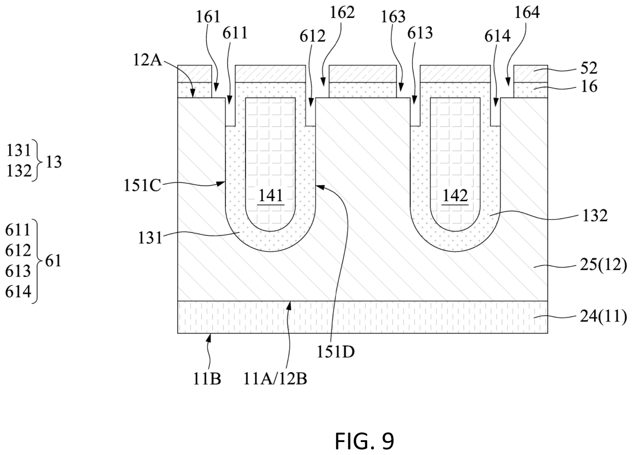

Referring to FIG. 9, the manufacturing method of the vertical semiconductor device 1 includes performing a first etching process on the hard mask layer 16 and the dielectric layer 13 using the patterned layer 52 as a mask, so as to form openings in the hard mask layer 16 and to respectively form recesses in the first dielectric layer 131 and the second dielectric layer 132. Since the first shield structure 151 and the second shield structure 152 have similar configurations, and the positions of the openings 523 and 524 relative to the second shield structure 152 are similar to the positions of the openings 521 and 522 relative to the first shield structure 151, for simplicity of description, the following description of the manufacturing steps mainly takes the first shield structure 151 and the openings 521 and 522 as examples. Subsequent steps for the second shield structure 152 may refer to those for the first shield structure 151.

In the first etching process, portions of the hard mask layer 16 and the first dielectric layer 131 located beneath openings 521 and 522 are selectively removed, thereby forming a plurality of openings in the hard mask layer 16 and a plurality of recesses 61 in the first dielectric layer 131. For example, openings 161 and 162, respectively corresponding to openings 521 and 522, are formed in the hard mask layer 16, and recesses 611 and 612 positioned beneath openings 161 and 162 are formed in the first dielectric layer 131. Recess 611 is connected to the bottom of opening 161 and communicates with opening 161, while recess 612 is connected to the bottom of opening 162 and communicates with opening 162. Recess 611 exposes a portion of the semiconductor material layer 12 that is adjacent to surface 12A and abuts sidewall 151C, and recess 612 exposes a portion of the semiconductor material layer 12 that is adjacent to surface 12A and abuts sidewall 151D. The first etching process removes dielectric material and stops on the semiconductor material layer 12. In some embodiments, the hard mask layer 16 and the first dielectric layer 131 are made of the same dielectric material, or both the hard mask layer 16 and the first dielectric layer 131 are composed of materials that exhibit a low etch-selectivity ratio to the etchant of the first etching process, so that the hard mask layer 16 can be removed together with the first dielectric layer 131. In some embodiments, the first etching process includes a dry-etch process, such that portions of the top surface 12 of the semiconductor material layer 12 located within openings 161 and 162 are exposed, and portions of the semiconductor material layer 12 in contact with the sidewalls of the first dielectric layer 131 are exposed by recesses 611 and 612.

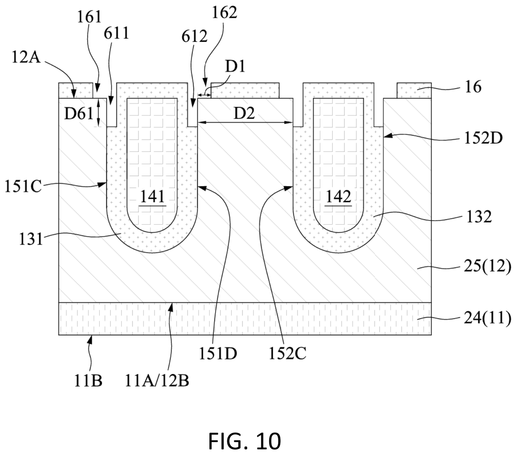

Referring to FIG. 10, the manufacturing method of the vertical semiconductor device 1 includes removing the patterned layer 52. In some embodiments, the openings 611 and 612 have approximately the same depth D61 in the vertical direction from the surface 12A. In some embodiments, a range of the depth D61 is between 0.5-1.5 µm. The openings 611 and 612 will define locations of portions of the gate structure, therefore, the depth D61 of the openings 611 and 612 may be adjusted by parameters (for example, energy, time, etc.) of the etching step described in FIG. 9 according to a breakdown voltage (BV) required by the vertical semiconductor device 1, to obtain a required depth D61. In addition, the openings 161 and 162 will expose portions of the surface 12A of the semiconductor material layer 12. In some embodiments, the exposed portion of the semiconductor material layer 12 has a width D1. In some embodiments, a range of the width D1 is greater than 0 and less than 2 µm. In some embodiments, a range of the width D1 is between 0.1-0.15 µm. The range of the width D1 may be adjusted according to a distance D2 between the first shield structure 151 and the second shield structure 152. In some embodiments, a range of the distance D2 is between 0.5-3 µm. In some embodiments, a range of the distance D2 is between 1-2 µm.

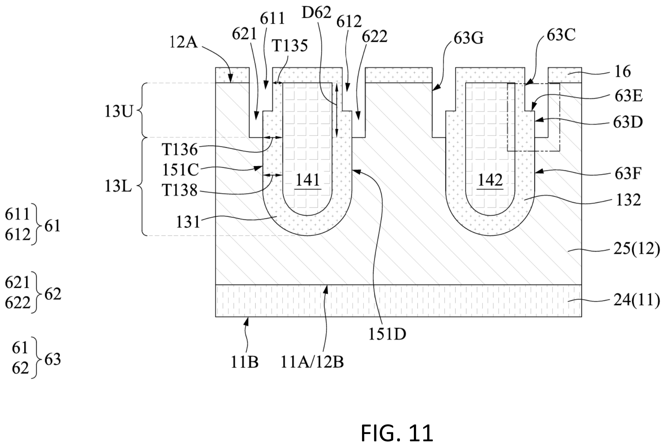

Referring to FIG. 11, the manufacturing method includes performing a second etching process on the semiconductor material layer 12 using the hard mask layer 16 and the dielectric layer 13 as a mask. Portions of the semiconductor material layer 12 are removed in the second etching process, thereby forming a plurality of recesses 62 in the semiconductor material layer 12. In some embodiments, the second etching process comprises a dry-etch process, such as an isotropic or anisotropic dry-etch process. The plurality of recesses 62 have substantially the same depth D62 in the vertical direction from the surface 12A, and the depth D62 is greater than the depth D61 of the recesses 61. In some embodiments, the recesses 62 expose portions of the sidewall 151C and portions of the sidewall 151D of the first dielectric layer 131 that are located beneath the recesses 61. Each recess 62 horizontally communicates with a respective recess 61. The plurality of recesses 62 include, for example, recesses 621 and 622 located in the first dielectric layer 131. In some embodiments, recess 621 horizontally communicates with recess 611 and has a depth greater than the depth of recess 611. In some embodiments, recess 622 horizontally communicates with recess 612 and has a depth greater than the depth of recess 612.

According to the configuration and position of the dielectric layer 13, for example, the dielectric layer 13 may be divided into an upper portion 13U and a lower portion 13L, with the bottom of recess 62 serving as the boundary between the two. For example, the first dielectric layer 131 located at one side of the first electrode layer 141 includes the upper portion 13U whose profile is narrow at the top and wide at the bottom. In other words, a thickness at a top of the upper portion 13U is smaller than a thickness at a bottom of the upper portion 13U. In some embodiments, the upper portion 13U has a thickness T135 along the horizontal direction at the level of the surface 12A of the semiconductor material layer 12, and the upper portion 13U has a thickness T136 along the horizontal direction at an interface of the semiconductor material layer 12 and the first dielectric layer 131, wherein the thickness T135 is less than the thickness T136. In some embodiments, a range of the thickness T135 is between 0.1-0.2 µm. Depending on the second etching process, the upper portion 13U may have a configuration with a flat and smooth sidewall whose thickness gradually increases in the vertical direction from surface 12A toward surface 12B, or it may have the stepped configuration shown in FIG. 11. The lower portion 13L of the first dielectric layer 131 has a uniform thickness, and the thickness of the lower portion 13L is approximately the same as the thickness of the dielectric layer 13 in FIG. 4. In some embodiments, the thickness T138 of the lower portion 13L is approximately equal to the thickness T136. In other words, the thickness T138 of the lower portion 13L is greater than the thickness T135 of the upper portion 13U.

The recesses 61 and 62 together define the location of the gate structure subsequently formed, therefore, the recesses 61 and 62 may also be collectively referred to as a gate trench 63. A depth of the gate trench 63 is less than a depth of the shield structure 15. Each gate trench 63 may have a similar configuration. The gate trench 63 has a first sidewall 63G away from the shield structure 15, a second sidewall (including 63C, 63E, and 63D) adjacent to the shield structure 15, and a bottom surface 63F connecting the first sidewall 63G and the second sidewall, wherein the first sidewall 63G is a flat sidewall defined by the semiconductor material layer 12, and the second sidewall is a sidewall having a stepped configuration defined by the upper portion 13U of the dielectric layer 13.

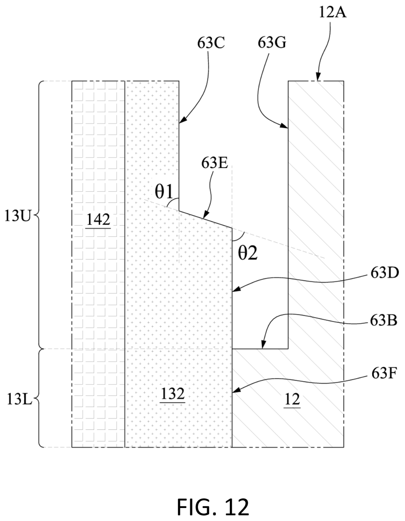

FIG. 12 is an enlarged view, according to some embodiments of the present disclosure, of the region outlined by the dashed box in FIG. 11. The second sidewall of the gate trench 63 (that is, the sidewall of the upper portion 13U of the dielectric layer 13) includes: a first sidewall portion 63C that extends in a first direction; a second sidewall portion 63D that is approximately parallel to the first sidewall portion 63C; and a third sidewall portion 63E that connects the first sidewall portion 63C and the second sidewall portion 63D and extends in a second direction. In some embodiments, the first direction is substantially parallel to the vertical direction. In some embodiments, an angle between the first direction and the second direction is between 30 ° and 90 °. In some embodiments, an included angle θ₁ between the first sidewall portion 63C and the third sidewall portion 63E is between 30 ° and 90 °. In some embodiments, an included angle θ₂ between the third sidewall portion 63E and the second sidewall portion 63D is between 30 ° and 90 °. The included angles θ₁ and θ₂ may be approximately the same (for example, differing by no more than 5 °) or different (for example, differing by more than 5 °). A bottom surface 63B may extend generally in the horizontal direction or may have an arcuate configuration, without limitation. In some embodiments, the sidewall of the lower portion 13L of the dielectric layer 13 (as exemplified by 132 in FIG. 12) that is adjacent to the semiconductor material layer 12 forms a continuous sidewall with the second sidewall portion 63D of the upper portion 13U.

FIGS. 11 and 12 illustrate, according to some embodiments of the present disclosure, a gate trench 63 having a sidewall with a stepped configuration. by controlling the first etching process and second etching process, recesses 61 and 62 can be formed to the same depth, so that the gate trench 63 has a columnar configuration.

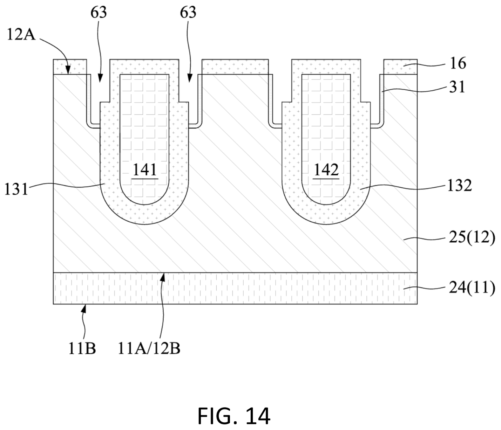

FIG. 14 illustrates a gate trench 63 having a columnar configuration according to various embodiments of the present disclosure. In the embodiment of FIG. 14, the second sidewall of the gate trench 63 is defined by the first sidewall portion 63C and does not have the second sidewall portion 63D and the third sidewall portion 63E. The first sidewall portion 63C of the gate trench 63 connects to a bottom surface 63B of the gate trench 63, wherein the bottom surface 63B is defined by a portion of the dielectric layer 13 and a portion of the semiconductor material layer 12.

As described above, the thickness of the dielectric layer 13 will determine the voltage rating of the vertical semiconductor device 1. If a width of a gate structure located in the dielectric layer 13 is too large, the breakdown performance of the vertical semiconductor device 1 will be impaired. Therefore, the depth D61 of the opening 61 is preferably less than or equal to the depth D62 of the opening 62. In practical operation, an etching process will have, more or less, an over-etching phenomenon, therefore, in order to ensure that the depth D61 of the opening 61 is not greater than the depth D62 of the opening 62, when controlling the first etching process, an etch depth will be set to be less than an etch depth set by the second etching process.

Refer to FIGS. 14-15, the manufacturing method includes, after the second etching process of FIG. 12, forming a sacrificial layer 31 on exposed portions of the semiconductor material layer 12 in the gate trench 63, and removing the sacrificial layer 31 before forming the gate structure. In some embodiments, the sacrificial layer 31 includes an oxide (for example, silicon oxide). In some embodiments, a thermal oxidation process is performed on the exposed semiconductor material layer 12 to form the sacrificial layer 31. Multiple preceding processes may cause damage to the surface of the semiconductor material layer 12, and the sacrificial layer 31 can planarize the surface of the exposed semiconductor material layer 12, which facilitates better performance of a gate structure formed thereafter.

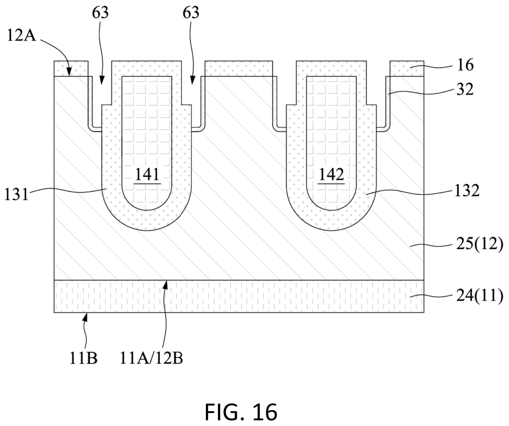

Referring to FIG. 16, the manufacturing method includes forming a gate dielectric layer 32 on the exposed portions of the semiconductor material layer 12. The formation of the gate dielectric layer 32 may follow the same procedures used for forming the dielectric layer 13, the first dielectric layer 131, and the second dielectric layer 132, and will not be repeated here. In some embodiments, a thermal-oxidation process is carried out to form the gate dielectric layer 32, wherein the gate dielectric layer 32 is formed only on the exposed portions of the semiconductor material layer 12. In some embodiments, a deposition process is employed to form the gate dielectric layer 32, wherein the gate dielectric layer 32 is conformally formed over the surfaces of the structure shown in FIG. 16 (including both the exposed portions of the semiconductor material layer 12 and the dielectric layer 13). The embodiment illustrated in FIG. 16 shows a gate dielectric layer 32 formed by thermal oxidation. In some embodiments, the thickness of the gate dielectric layer 32 is less than the thickness T135 defined in FIG. 11. In embodiments in which the gate dielectric layer 32 is formed by a deposition process, because part of the gate dielectric layer 32 will lie on the dielectric layer 13, it is only necessary that the total thickness of the gate dielectric layer 32 and the dielectric layer 13 falls within the thickness ranges T135 and T136 described above.

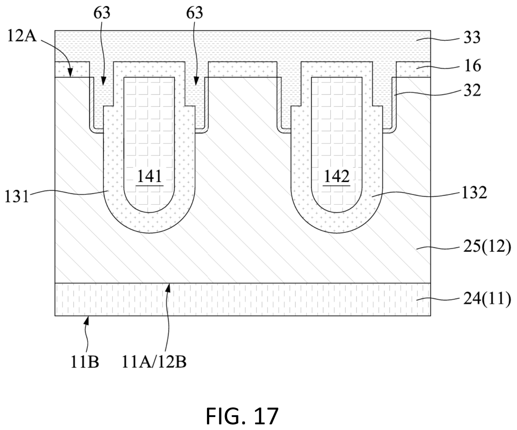

Referring to FIGS. 17-18, the manufacturing method includes forming a gate electrode 34 in the gate trench 63. The gate dielectric layer 32 surrounds the gate electrode 34. In some embodiments, the gate electrode 34 may be formed by physical vapor deposition, for example, sputtering or spraying. In some embodiments, the gate electrode 34 may be formed by electroplating or CVD. In some embodiments, an electrode material layer 33 is formed so that it fills the gate trench 63 and covers the surface 12A. A subsequent grinding process, for example, a chemical mechanical polishing process, is then performed to planarize and remove the electrode material layer 33 outside the gate trench 63 so as to form a plurality of gate electrodes 34 (including 341, 342, 343, and 344) in each gate trench 63. In some embodiments, the gate electrode 34 is adjacent to an upper portion 13U of the dielectric layer 13 of the shield structure 15.

In some embodiments, portions of the electrode material layer 33 are removed while simultaneously removing the hard mask layer 16 on the surface 12A, so as to expose the surface 12A. In some embodiments, the electrode material layer comprises polysilicon. In some embodiments, the top surface of the gate electrode 34 is coplanar with the surface 12A. For convenience of description, each gate electrode 34 and its corresponding gate dielectric layer 32 may be collectively referred to as a gate structure 35.

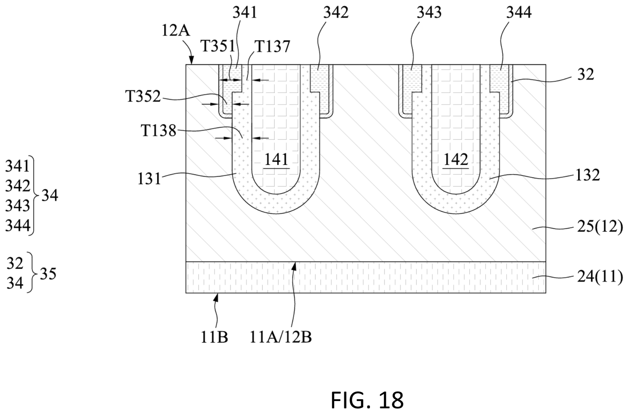

Each gate structure 35 has a similar configuration, defined by the configuration of the gate trench 63. Therefore, the gate structure 35 has a configuration that is wider at the top and narrower at the bottom. For example, taking the third sidewall portion 63E of FIG. 11 as a boundary, a width T351 of an upper portion of the gate structure 35 is greater than a width T352 of a lower portion of the gate structure 35. In some embodiments, a range of the width T351 of the upper portion of the gate structure 35 is between 0.6 and 0.8 µm. In some embodiments, a thickness T137 of the dielectric layer 13 adjacent to the upper portion of the gate structure 35 is between 0.1 and 0.2 µm. It should be noted that the thickness T135 in FIG. 11 is measured at a horizontal level of the surface 12A, and the thickness T137 in FIG. 18 may be a thickness of the dielectric layer 13 at any location above the third sidewall portion 63E, including a thickness at the horizontal level of the surface 12A.

Measured along the horizontal direction at the same level, a sum of a width of the gate structure 35 and the thickness of the upper portion 13U of the dielectric layer 13 is greater than or equal to a thickness T138 of the lower portion 13L of the dielectric layer 13. In some embodiments, a ratio of a sum of the width T351 and the thickness T137 to the thickness T138 of the lower portion 13L of the dielectric layer 13 (that is, (T351 + T137): T138) is greater than or equal to 1:1. In some embodiments, the width T351 may be a width of an upper portion of the gate structure 35 at the horizontal level of the surface 12A. Since the gate dielectric layer 32 has a uniform thickness, a contour of the gate electrode 34 is consistent with a contour of the gate trench 63, in other words, a spacing between the two has a conformal relationship. In some embodiments, a sum of a width of the gate electrode 34 at the horizontal level of the surface 12A and a thickness T135 of the upper portion 13U of the dielectric layer 13 at the horizontal level of the surface 12A is greater than or equal to the thickness T138 of the lower portion 13L of the dielectric layer 13.

The semiconductor material layer 12 between adjacent shield structures 15 has a mesa-like profile, also referred to as a mesa region. A portion of the gate structure 35 of the vertical semiconductor device 1 of the present application is located in the mesa region, and another portion is located in the dielectric layer 13 of the shield structure 15. By controlling widths of the gate structure 35 in the mesa region and in the dielectric layer 13, an effective area of the gate structure 35 (that is, the cross-sectional area seen in FIG. 18) can be increased without affecting product specifications, thereby achieving an improvement of gate resistance.

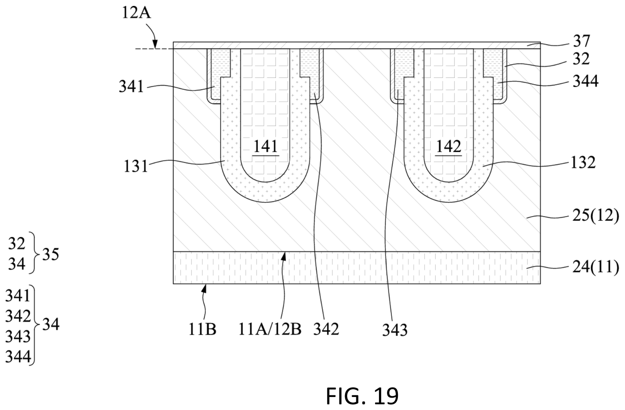

Referring to FIG. 19, the manufacturing method includes forming an oxide layer 37 on the surface 12A of the semiconductor material layer 12. In some embodiments, the oxide layer 37 covers the semiconductor material layer 12, the gate structure 35, and the shield structure 15. In some embodiments, the oxide layer 37 can protect the surface of the semiconductor material layer 12 in subsequent ion implantation steps, reduce surface damage, and control of the thickness of the oxide layer 37 will not affect the efficiency of ion implantation. In some embodiments, configurations of the gate structures 35 positioned on two sides of the electrode material layer 14 within the shield structure 15 are substantially symmetrical. In some embodiments, configurations of the gate structures 35 on two sides of the mesa region are substantially symmetrical.

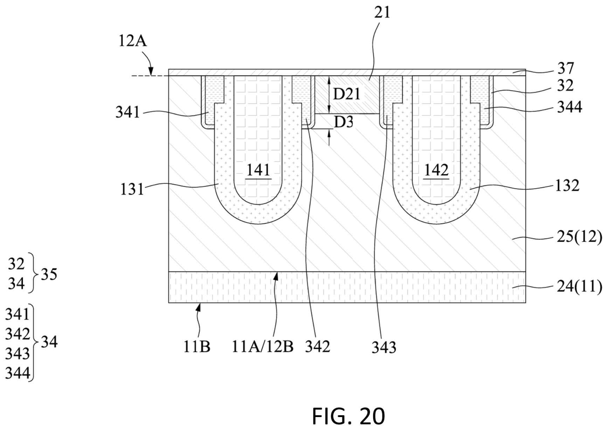

Referring to FIGS. 20-21, the manufacturing method includes performing a first ion implantation process on the semiconductor material layer 12 to form a body doped region 21, and a second ion implantation process to form a source doped region 22. The body doped region 21 has a conductivity type different from that of the lightly doped region 25. A depth of the body doped region 21 determines a channel region. The body doped region 21 is located between adjacent gate structures 35, adjacent to the surface 12A in the vertical direction, and adjacent to the gate structures 35 in the horizontal direction. The body doped region 21 has a depth D21 from the surface 12A in the vertical direction, and the depth D21 is less than the depth D62 of the recesses 62. In some embodiments, there is a distance D3 between a bottom of the body doped region 21 and a bottom of the gate structure 35 (that is, a difference between the depth D62 and the depth D21), where a range of the distance D3 is between 0.1-0.2 µm. The source doped region 22 has the same conductivity type as the lightly doped region 25, and a doping concentration of first-conductivity-type ions of the source doped region 22 is greater than a doping concentration of first-conductivity-type ions of the lightly doped region 25. The source doped region 22 is located between adjacent gate structures 35 and is adjacent to the surface 12A. The source doped region 22 has a depth D22 from the surface 12A in the vertical direction, and the depth D22 is less than the depth D22 of the body doped region 21. In some embodiments, the doping concentration of first-conductivity-type ions of the source doped region 22 is greater than a doping concentration of second-conductivity-type ions of the body doped region 21. In some embodiments, a thermal annealing process is performed after forming the body doped region 21 to diffuse ions and activate the body doped region 21. In some embodiments, a thermal annealing process is performed after forming the source doped region 22 to diffuse ions and activate the source doped region 22.

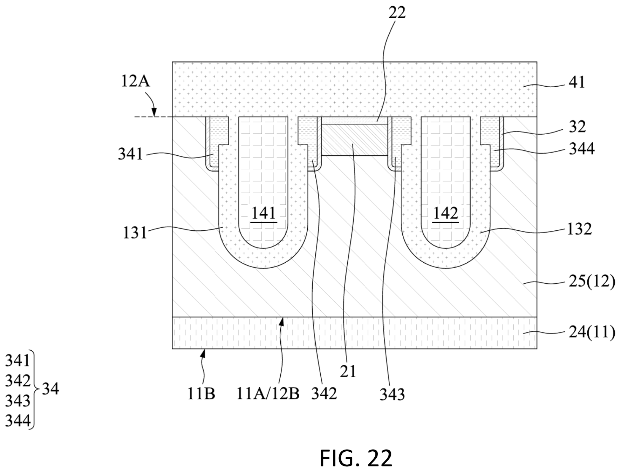

Referring to FIG. 22, the manufacturing method includes forming an interlayer dielectric (ILD) 41 on the surface 12A of the semiconductor material layer 12. The interlayer dielectric 41 may be formed by ALD, CVD, or other deposition processes.

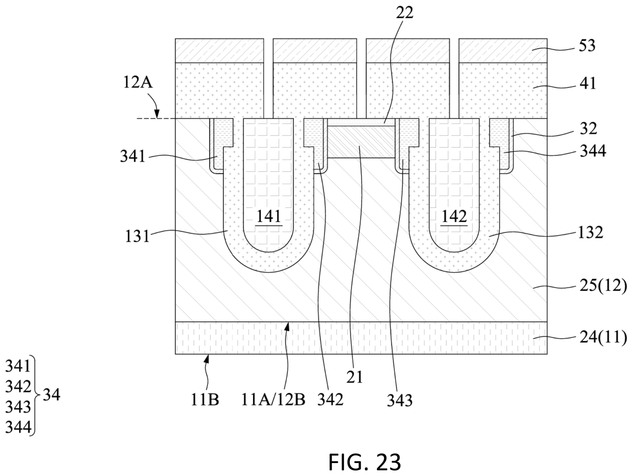

Referring to FIGS. 23-24, the manufacturing method includes locally removing portions of the interlayer dielectric 41, and locally removing portions of the semiconductor material layer 12, the first electrode layer 141, and the second electrode layer 142 using the interlayer dielectric 41 as a mask. In some embodiments, a patterned layer 52 is formed on the interlayer dielectric 41, and an etching process is performed on the interlayer dielectric 41 using the patterned layer 52 as a mask. The patterned layer 52 may be a photoresist layer. In some embodiments, materials of the semiconductor material layer 12, the first electrode layer 141, and the second electrode layer 142 include polysilicon, so a single etching process may be used for removing them locally. In some embodiments, the patterned layer 52 is removed before locally removing the semiconductor material layer 12, the first electrode layer 141, and the second electrode layer 142. In some embodiments, openings 411, 412, and 413 are respectively formed in the first electrode layer 141, the semiconductor material layer 12, and the second electrode layer 142. In some embodiments, the openings 411, 412, and 413 have approximately the same depth. In some embodiments, a depth of the opening 412 is greater than a depth D21 of the body doped region 21.

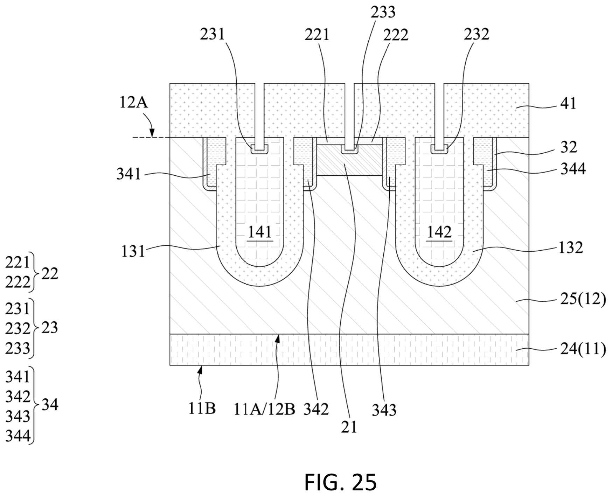

Referring to FIG. 25, the manufacturing method includes performing ion implantation processes on the first electrode layer 141, the semiconductor material layer 12, and the second electrode layer 142 through openings 411, 412, and 413 to form a plurality of heavily doped regions 23 (for example, 231, 232, and 233). Ions are implanted along the vertical direction into the first electrode layer 141, the semiconductor material layer 12, and the second electrode layer 142 at bottoms of the openings 411, 412, and 413. The heavily doped regions 231 and 233 are respectively formed in the electrode material layer 14 adjacent to the bottoms of the openings 411 and 413, and the heavily doped region 232 is formed in the semiconductor material layer 12 adjacent to the bottom of the opening 412. In some embodiments, an annealing process is performed after the ion implantation processes to form the heavily doped regions 231, 232, and 233 shown in FIG. 25.

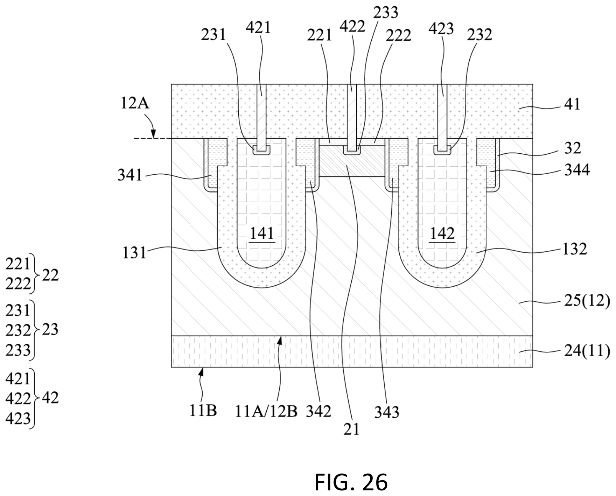

Referring to FIG. 26, the manufacturing method includes forming a plurality of conductive plugs 42 (including 421, 422, and 423) in the openings 411, 412, and 413. The conductive plugs 42 may be formed by filling a conductive material into the openings 411, 412, and 413 by electroplating or CVD. Materials of the conductive plugs 42 may include gold (Au), silver (Ag), copper (Cu), platinum (Pt), palladium (Pd), tungsten (W), titanium (Ti), tantalum (Ta), molybdenum (Mo), titanium nitride (TiN), tantalum nitride (TaN), aluminum-copper (AlxCuy), silicon-copper (SixCuy), alloys thereof, or combinations thereof.

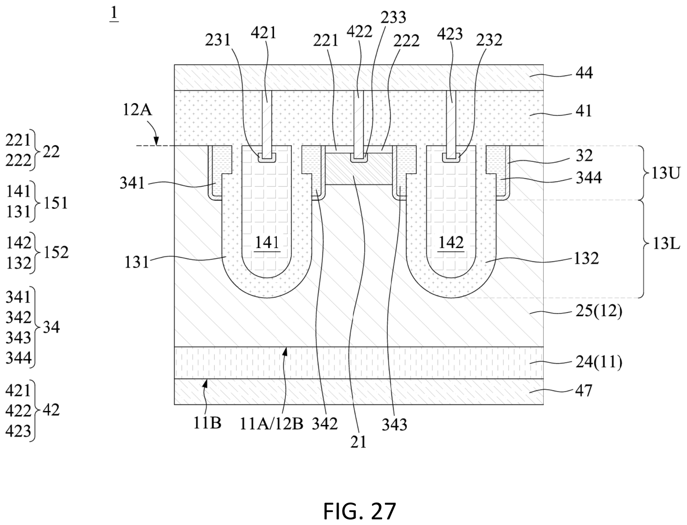

Referring to FIG. 27, the manufacturing method includes forming a source electrode layer 44 and a drain electrode layer 47 on opposite sides of the semiconductor material layer 12. The source electrode layer 44 is formed on the interlayer dielectric layer 41 and the conductive plugs 42. The source electrode layer 44 may include suitable metal materials or alloys, for example titanium tungsten (TiW), aluminum (Al), aluminum-silicon alloy (AlSi), aluminum-silicon-copper alloy (AlSiCu), or combinations thereof, and is not limited thereto. After forming the source electrode layer 44, the source electrode layer 44 may be etched to form a desired pattern. Since the etching step is performed according to the required circuit design, the figures do not illustrate the etching steps, and a person skilled in the art can adjust the etching steps based on the above disclosure to form the desired pattern of the source electrode layer 44.

The drain electrode layer 47 is formed on a bottom surface 11B of the substrate 11. The drain electrode layer 47 may include the same metal material or alloy as the source electrode layer 44. After forming the drain electrode layer 47, the drain electrode layer 47 may be etched to form a desired pattern. Since the etching step is performed according to the required circuit design, the figures do not illustrate the etching steps, and a person skilled in the art can adjust the etching steps based on the above disclosure to form the desired pattern of the drain electrode layer 47.

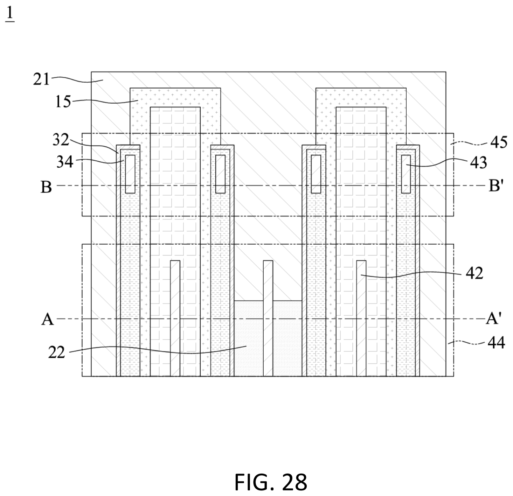

FIG. 28 is a top view of the vertical semiconductor device 1 in accordance with some embodiments of the present disclosure. FIGS. 1-27 are cross-sectional views, taken along section line A-A', illustrating successive stages of the corresponding manufacturing method in accordance with some embodiments of the present disclosure. During the step of forming the conductive plug 42, a plurality of gate conductive plugs 43 are formed simultaneously, electrically connecting to the gate structures 35. During the step of forming the source-electrode layer 44, a gate-electrode layer 45 may be formed simultaneously by means of an etching step. In some embodiments, the gate-electrode layer 45 and the source-electrode layer 44 are located at approximately the same horizontal level. From the top view in FIG. 28, one portion of the gate structure 35 overlaps the shield structure 15, while another portion of the gate structure 35 lies outside the coverage range of the shield structure.

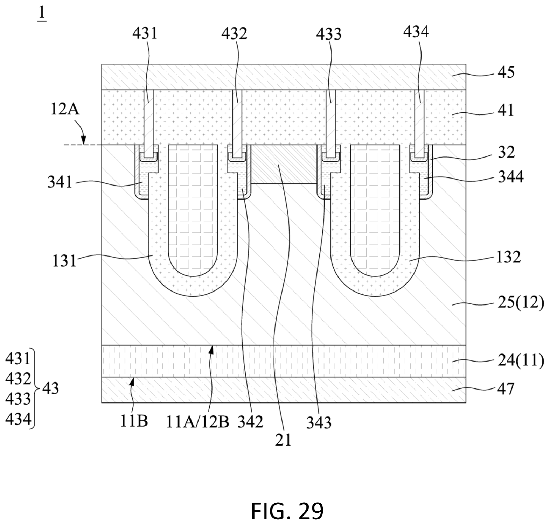

FIG. 29 is a cross-sectional view, taken along line B-B' of FIG. 28, showing the manufacturing method according to some embodiments of the present disclosure. In some embodiments, the depth of the gate conductive plug 43 is approximately the same as the depth of the conductive plug 42. In some embodiments, the gate conductive plug 43 comprises 431, 432, 433, and 434, which respectively connect to the gate electrodes 341, 342, 343, and 344. In some embodiments, the heavily doped region 23 further comprises 234, 235, 236, and 237, which are respectively formed in the gate electrodes 341, 342, 343, and 344 and are respectively adjacent to the bottoms of the gate conductive plugs 431, 432, 433, and 434.

In this disclosure, for description convenience, spatially relative terms such as "below", "under", "lower", "above", "upper", "left side", "right side", and so on, may be used to describe the relationship of one component or feature with another one or more components or features, as shown in the accompanying drawings. The spatially relative terms are not only used to depict the orientations in the accompanying drawings, but also intended to encompass different orientations of a device in use or operation. A device may be oriented in other ways (rotated 90 degrees or in other orientations), and the spatially relative terms used herein may be interpreted in a corresponding way similarly. It should be understood that when a component is referred to as being "connected to" or "coupled to" another component, it can be directly connected or coupled to another component or an intervening component may be present.

As used herein, the terms "approximately", "basically", "substantially" and "about" are used to describe and account for small variations. When used in conjunction with an event or instance, the terms may refer to an embodiment of exact occurrence of an event or instance as well as an embodiment where the event or instance is close to occurrence. As used herein with respect to a given value or range, the term "about" generally means being within ±10%, ±5%, ±1%, or ±0.5% of the given value or range. A range herein may be referred to as being from one endpoint to the other or as being between two endpoints. All ranges disclosed herein are inclusive of the endpoints unless otherwise indicated. The term "substantially coplanar" may mean that the difference of positions of two surfaces with reference to the same plane is within a few micrometers (µm), e.g., within 10 µm, within 5 µm, within 1 µm, or within 0.5 µm. When values or characteristics are referred to as being "substantially" the same, the term may refer to a value that is within ±10%, ±5%, ±1%, or ±0.5% of the mean of the values.

The foregoing has outlined features of some embodiments and detailed aspects of present disclosure. The embodiments described in the present disclosure may be readily used as a basis for designing or modifying other processes and structures in order to carry out the same or similar purposes and/or to achieve the same or similar advantages of the embodiments presented herein. Such equivalent constructions do not depart from the spirit and scope of the present disclosure, and various changes, substitutions, and alterations can be made without departing from the spirit and scope of the present disclosure.

## Claims

1. A vertical semiconductor device, comprising:
a semiconductor material layer having a first surface and a second surface opposite each other;
a first shield structure located in the semiconductor material layer and extending from the first surface toward the second surface, the first shield structure comprising a first shield dielectric layer and a first shield electrode surrounded by the first shield dielectric layer;
a first doped region located in the semiconductor material layer and adjacent to the first surface, the first doped region having a first conductivity type; and
a first gate structure located in the semiconductor material layer and extending from the first surface toward the second surface, the first gate structure being adjacent to the first doped region, a depth of the first gate structure being less than a depth of the first shield structure and greater than a depth of the first doped region, wherein:
a bottom of the first gate structure defines a boundary that divides the first shield dielectric layer into an upper portion and a lower portion, and the first gate structure is adjacent to the upper portion of the first shield dielectric layer;
the upper portion of the first shield dielectric layer has a first thickness at the first surface of the semiconductor material layer, the first thickness being less than a second thickness of the lower portion of the first shield dielectric layer; and
a sum of the first thickness of the upper portion of the first shield dielectric layer and a third thickness of the first gate structure at the first surface is greater than the second thickness of the lower portion of the first shield dielectric layer.

2. The vertical semiconductor device of claim 1, wherein the first gate structure comprises:
a first gate electrode, the first gate electrode contacting the upper portion of the first shield dielectric layer; and
a first gate dielectric layer located between the first gate electrode and the semiconductor material layer.

3. The vertical semiconductor device of claim 2, wherein a width of a top portion of the first gate electrode is greater than a width of a bottom portion of the first gate electrode.

4. The vertical semiconductor device of claim 2 or 3, wherein a sum of a width of the first gate electrode at the first surface and the first thickness of the upper portion of the first shield dielectric layer is greater than or equal to the second thickness of the lower portion of the first shield dielectric layer.

5. The vertical semiconductor device of any preceding claim, wherein the first gate structure comprises a first sidewall away from the first shield structure and a second sidewall adjacent to the first shield structure, the first sidewall being a flat sidewall and the second sidewall being a sidewall having a stepped configuration.

6. The vertical semiconductor device of any preceding claim, wherein, in a top view, a portion of the first gate structure overlaps the first shield structure, and a portion of the first gate structure located outside a coverage range of the first shield structure.

7. The vertical semiconductor device of any preceding claim, wherein the upper portion of the first shield dielectric layer comprises a first sidewall portion extending along a first direction, a second sidewall portion substantially parallel to the first sidewall portion, and a third sidewall portion connecting the first sidewall portion and the second sidewall portion and extending along a second direction, an included angle between the first direction and the second direction being between 30 ° and 90 °.

8. The vertical semiconductor device of any preceding claim, further comprising:
a second shield structure located in the semiconductor material layer and extending from the first surface toward the second surface, the second shield structure being adjacent to the first shield structure, the first doped region being located at least between the first shield structure and the second shield structure, the second shield structure comprising a second shield dielectric layer and a second shield electrode surrounded by the second shield dielectric layer; and
a second gate structure located in the semiconductor material layer and extending from the first surface toward the second surface, a configuration of the second gate structure being substantially symmetric to a configuration of the first gate structure.

9. The vertical semiconductor device of any preceding claim, further comprising:
a second doped region located in the semiconductor material layer and adjacent to the first surface, the second doped region being within the first doped region and having a second conductivity type different from the first conductivity type, and a depth of the first doped region being greater than a depth of the second doped region.

10. The vertical semiconductor device of any preceding claim, further comprising:
a source-electrode layer located over the first surface of the semiconductor material layer;
a first conductive plug electrically connected to the first shield structure; and
a third doped region located within the first shield electrode and adjacent to the first conductive plug, a concentration of dopants of the first conductivity type in the third doped region being greater than a concentration of dopants of the first conductivity type in the first doped region.

11. A method for manufacturing a vertical semiconductor device, comprising:
forming a first shield structure in a lightly doped region of a semiconductor material layer, the lightly doped region having a first conductivity type, the first shield structure comprising a first shield electrode and a first shield dielectric layer located between the first shield electrode and the semiconductor material layer;
forming a first patterned layer on the semiconductor material layer, the first patterned layer having a first opening, wherein a first sidewall of the first opening is located above the first shield dielectric layer located between the first shield electrode and the semiconductor material layer, and a first sidewall of the first shield dielectric layer is located within a coverage range of the opening;
performing a first etching process on the first shield dielectric layer to form a first recess in the first shield dielectric layer, the first recess exposing a portion of the semiconductor material layer;
performing a second etching process on the semiconductor material layer to form a second recess in the semiconductor material layer, a depth of the second recess being greater than a depth of the first recess, the second recess exposing the first sidewall of the first shield dielectric layer located below the first recess, and the first recess communicating with the second recess to define a third recess; and
forming a first gate structure in the third recess.

12. The method of claim 11, wherein forming the first shield structure comprises:
forming a first trench in the semiconductor layer;
forming the first shield dielectric layer along sidewalls of the first trench; and
forming the first shield electrode in the first trench, a top surface of the first shield electrode, a top surface of the first shield dielectric layer, and a top surface of the semiconductor material layer being at approximately the same level.

13. The method of claim 11 or 12, further comprising:
after forming the first gate structure, performing a first ion implantation process on the semiconductor material layer to form a body doped region, the body doped region having a second conductivity type different from that of the lightly doped region.

14. The method of claim 13, wherein a depth of the body doped region is less than a depth of the first gate structure.

15. The method of claim 13 or 14, further comprising:
performing a second ion implantation process on the semiconductor material layer to form a source doped region, wherein the source doped region has the same first conductivity type as the lightly doped region, and a concentration of dopants of the first conductivity type in the source doped region is greater than a concentration of dopants of the first conductivity type in the lightly doped region.

16. The method of any of claims 11-15, wherein the second recess exposes a portion of the semiconductor material layer adjacent to the first shield structure, and further comprising:
after the second etching process, forming a first sacrificial layer on an exposed portion of the semiconductor material layer in the second recess; and
removing the first sacrificial layer before forming the first gate structure.

17. The method of any of claims 11-16, wherein forming the first gate structure comprises:
forming a first gate dielectric layer on the semiconductor material layer in the third recess; and
forming a first gate electrode in the third recess, a width of an upper portion of the first gate electrode being greater than a width of a lower portion of the first gate electrode.

18. The method of claim 17, wherein the width of the upper portion of the first gate electrode is between 0.6 µm and 0.8 µm.

19. The method of claim 17 or 18, wherein a portion of the first shield dielectric layer adjacent to the upper portion of the first gate electrode has a thickness is between 0.1 µm and 0.2 µm.

20. The method of any of claims 11-19, wherein a thickness of the first shield dielectric layer beneath the first gate electrode is between 0.6 µm and 0.8 µm.

21. The method of any of claims 11-20, further comprising:
forming a first conductive plug electrically connected to the first shield structure; and
forming a second conductive plug electrically connected to the first gate structure.

22. The method of claim 21, wherein a depth of the first conductive plug or the second conductive plug in the semiconductor material layer is greater than a depth of the source doped region in the semiconductor material layer.

23. The method of any of claims 11-22, wherein at least one of the first etching process and the second etching process is a dry etching process.
